Europäisches Patentamt

European Patent Office

Office européen des brevets

(19)

(11) **EP 1 131 874 B1**

(12) **EUROPÄISCHE PATENTSCHRIFT**

| | |
|---|---|
| (45) Veröffentlichungstag und Bekanntmachung des Hinweises auf die Patenterteilung: **18.09.2002 Patentblatt 2002/38** | (51) Int Cl.⁷: **H02H 7/20**, H03K 3/53 |

(21) Anmeldenummer: **99953871.3**

(22) Anmeldetag: **18.10.1999**

(86) Internationale Anmeldenummer: **PCT/EP99/07882**

(87) Internationale Veröffentlichungsnummer: **WO 00/030234 (25.05.2000 Gazette 2000/21)**

(54) **SCHUTZSYSTEM IN EINEM LEISTUNGSMODULATOR ZUM SCHUTZE DER LAST**

LOAD PROTECTION SYSTEM IN A POWER MODULATOR

SYSTEME DE PROTECTION DE CHARGE INSTALLE DANS UN MODULATEUR DE PUISSANCE

(84) Benannte Vertragsstaaten:
**AT BE CH CY DE DK ES FI FR GB GR IE IT LI LU MC NL PT SE**

(30) Priorität: **16.11.1998 DE 19852723**

(43) Veröffentlichungstag der Anmeldung:
**12.09.2001 Patentblatt 2001/37**

(73) Patentinhaber: **Forschungszentrum Karlsruhe GmbH**
**76133 Karlsruhe (DE)**

(72) Erfinder:
 • **KUPERMAN, Grigory**
  **D-76149 Karlsruhe (DE)**
 • **JÜNGST, Klaus-Peter**
  **D-76297 Stutensee (DE)**

(74) Vertreter: **Rückert, Friedrich, Dr.**
 **Forschungszentrum Karlsruhe GmbH,**
 **Abt. PAL,**
 **Postfach 36 40**
 **76021 Karlsruhe (DE)**

(56) Entgegenhaltungen:
 **DE-C- 4 440 013        US-A- 3 786 275**

**Beschreibung**

Die Erfindung betrifft ein Schutzsystem in einem Leistungsmodulator zum Schutze der angeschlossenen Last. Der Leistungsmodulator ist eine Einrichtung, der hochleistungsimpulstechnische Baukomponenten als Last elektrisch versorgt. Solche Baukomponenten sind, wie z. B. ein Klystron oder ein Hochleistungssenderöhre, sehr teure Komponenten, die vor einem zerstörerischem Betrieb, wie einem Durchschlag zu hoher Leistung in ihnen, geschützt werden müssen.

Zur Erzeugung von Hochleistungspulsen werden Energiespeicher benötigt, die die für den Puls benötigte Energie zwischenspeichern und binnen kürzester Zeit an die Last abgeben können. Als Energiespeicher werden pulsformende Netzwerke (PFN), sowie große Kapazitäten oder Induktivitäten benutzt. Die Energie variiert je nach Anwendung von unter 1 kJ z. B. in der Radartechnik bis zu einigen MJ in Anlagen für die Kernfusion. Dabei darf die Energie, die bei einem Durchschlag in der Last, z. B. in einem Leistungsklystron, freigesetzt werden kann, einen Betrag von 20 bis 30 J nicht übersteigen.

Ein Modulator, der einen kapazitiven Speicher benutzt, ist von den Fermi National Accelerator Laboratories entwickelt worden.(siehe Konferenzbericht anläßlich des Twentyfirst International Power Modulator Symposium, 1994; June 27-30, 1994, Westen Sott Toast, Plasma Hotel, Costa Mesa Califomia; H. Pfeffer et. al., 3.3: "A Long Pulse Modulator for Reduced Size and Cost"). Dieser Modulator benutzt eine geschaltete Kondensatorbank mäßiger Größe, deren Spannung während des Pulses auf etwa 20 % der Anfangsspannung abfällt. Die in der Kondensatorbank gespeicherte Energie beträgt ca. 70 kJ. Die Kondensatorbank ist an die hochpotentiale Seite des Eingangs eines Pulstransformators über eine Kaskade von Gate-Turn-Off-Thyristoren (GTO) angeschlossen.

Ein Verfahren und einen Schaltkreis zum Schutz einer linearen Strahleinrichtung, wie ein Klystron, vor Zerstörung durch einen Kathoden-Masse-Kurzschluß wird in der US 3,786,275 als Patent vorgestellt. Die lineare Strahleinrichtung wird im Masseteil und in der Kollektor-Elektroden-Spannung von in Reihe geschalteten Netzgeräten, welche beide auf die Kathoden-Elektrode bezogen sind, versorgt. Eine Diode, so gepolt, daß der Stromfluß weg von der Kollektor-Elektrode unterbunden wird, ist zwischen der Kollektor-Elektrode und der Verbindung zwischen den Netzgeräten vorgesehen. Die Diode verhindert so den Hochstromfluß von der Kollektor-Versorgung, die von einem Kurzschluß zwischen Kathode und Masseteil herrührt.

Während des Impulses ist eine ziemlich große Energie in der Streuinduktivität und in der Hauptinduktivität des Impulstransformators gespeichert. Die Größe dieser Energie (Energie in der Streuinduktivität plus Energie in der Hauptinduktivität des Impulstransformators ist in etwa gleich, ca. 400 J) überschreitet um mehr als eine Größenordnung die zulässige Energie, welche im Klystron bei einem Durchschlag freigesetzt werden darf. Bei einem Durchschlag im Klystron gibt das Steuersystern ein Signal an den GTO-Schalter zum Trennen der Kondensatorbank von dem Impulstransformator sowie auch an den Ignitron-Schalter, der ein schnelles Entladen der Kondensatorbank über einen kleinen Widerstand sichert. Dabei wird die in der Kondensatorbank gespeicherte Energie in dem Widerstand in thermische umgesetzt.

Nach dem Trennen der Kondensatorbank von der Last wird die in der Streuinduktivität des Impulstransformators gespeicherte Energie fast völlig in der speziellen Zweipol-Schutzschaltung freigesetzt, die parallel zur Primärwicklung des Impulstransfonnators geschaltet ist. D.h., bei einer normalen Funktion des Modulators überschreitet die bei einem Durchschlag im Klystron freigesetzte Energie nicht den zulässigen Wert von 20 J. Jedoch wird im Fall einer Fehlfunktion des GTO-Schalters oder seines Steuersystems die o. e. parallel zur Primärwicklung des Impulstransformators geschaltete Schutzschaltung durch den Stromkreis des Ignitron-Schalters überbrückt. In diesem Fall wird fast die gesamte im Impulstransformator gespeicherte Energie im Klystron freigesetzt, die es zerstören kann.

In Modulatoren mit einem induktiven Speicher (siehe in dem Konferenzbeitrag anläßlich des o. e. Power Modulator Symposium in Costa Mesa H. Salbert et. al. unter 3.4: "Generation of High-Power Pulses Using a SMES") entstehen ähnliche Probleme.

Der Erfindung liegt die Aufgabe zugrunde, in einem Leistungsmodulator mit z. B. einem Klystron als Last das vorhandene Schutzsystem so zu erweitern und zu verbessern, daß die im Klystron bei einem Durchschlag freigesetzte Energie wesentlich kleiner ist und in der zulässigen Grenzen liegt, selbst wenn die derzeit üblichen Schutzvorrichtungen versagen.

Die Aufgabe wird durch eine ergänzende Schutzschaltung gemäß den kennzeichnenden Merkmalen des Anspruchs 1 gelöst. Dabei löst der Anspruch 1 die Aufgabe prinzipiell. Der Fehlerfall kann bei dieser prinzipiellen Schaltung in beiden Stromrichtungen erfolgen. In Anspruch 3 ist der Fehlerfall in der Last durch die Diode im Kreis nur in einer zulässigen Stromrichtung in der Last vorgesehen. In der entgegengesetzten Stromrichtung ist mit der Diode in Reihe zu der Last und der Schutzbeschaltung ein so hoher, richtungsabhängiger Widerstand eingebaut, daß sich in Sperrichtung überhaupt kein hoher Strom ausbilden kann.

Der Leistungsmodulator besteht von den Komponenten her aus einem Aufladungssystem, einem Leistungsimpulsformer, einem Pulstransformator und der angeschlossenen Last. Die zusätzliche oder ergänzende Schutzschaltung befindet sich auf der Lastseite des Pulstransformators zwischen der niederpotentialen Klemme des Pulstransformators und dem Erdpotential. Sie besteht aus einem gesteuerten Schalter, der durch einen Widerstand überbrückt ist. Der Widerstand ist in seiner Größe und Schutzfunktion an die Dimensionierung des Leistungsmodulators angepaßt (Anspruch 1). Statt des Widerstandes alleine kann die Reihenschaltung aus dem Widerstand und einem Kondensator den gesteuerten Schalter überbrücken, wobei die Dimensionierung des Widerstandes und der Kapazität ebenfalls an die Funktion angepaßt ist (Anspruch 2).

Soll der Fehlerfall nur für eine Stromrichtung auftreten können, in der entgegengesetzten jedoch nicht, liegt in Reihe zu der Schutzschaltung aus Anspruch 1 oder 2 und der Last eine Diode (Anspruch 3). Die Diode verhindert, daß in ihrer Sperrichtung ein nennenswerter Strom fließen kann.

Anspruch 4 kennzeichnet einen Widerstand vorgebbarer Größe, der die Diode überbrückt. Mit ihm wird der Spannungsabfall an der Diode begrenzt.

Wenn die Last (Anspruch 5) des Modulators ein Klystron ist, ist die Anode der Diode mit der niederpotentialen Klemme des Pulstransformators auf der Lastseite und die Kathode mit dem nicht an Erdpotential liegenden Kontakt des Schalters verbunden oder gleich wirksam: die Diode liegt mit dieser Orientierung zwischen Erdpotential und steuerbarem Schalter.

Der Vorteil des so aufgebauten Modulators liegt darin, daß der Anteil der Energie aus dem Impulstransformator, welcher in verschiedenen Fehlerfällen im Klystron freigesetzt wird, durch den Einsatz der beschriebenen zusätzlichen Schaltung entscheidend verringert wird:

- z. B. wird im Fall eines Versagens des Kommutators im Entladestromkreis des Energiespeichers die Energie aus der Streuinduktivität des Impulstransformators über dem parallel zu dem Schalter geschalteten Ballastwiderstand entladen;
- durch die o. e. Diode wird außerdem die Wahrscheinlichkeit eines wiederholten Durchschlages des Klystrons während der Änderung der Polarität der anliegenden Hochspannung entscheidend verringert;
- im dem Fall, daß dennoch ein wiederholter Durchschlag des Klystrons während der Änderung der Polarität der anliegenden Hochspannung erfolgt, wird der Großteil der in der Hauptinduktivität des Impulstransformators gespeicherten Energie nicht mehr im Klystron, sondern in der vorgeschlagenen Schutzschaltungseinheit und in der o. e. eingangsseitigen Zusatzbeschaltung freigesetzt;
- außerdem gewährleistet die zusätzliche Schutzbeschaltung eine wesentliche Verringerung der durch die Schutzschalter zu kommutierenden Leistung.

Die Erfindung wird anhand eines Durchführungsbeispiels und in Anlehnung an die Zeichnungen näher erläutert.

Es zeigen:

Figur 1 der Modulator mit der zusätzliche Schutzschaltung auf der Lastseite,

Figur 2 die RC-Überbrückung des Schalters,

Figur 3 die Diode in Reihe zu der Last und Schutzschaltung,

Figur 4 die mit einem Widerstand überbrückte Diode bei rein ohmscher Überbrückung des Schalters,

Figur 5 die Diode in Reihe zu der Last und Schutzschaltung bei RC-Überbrückung des Schalters,

Figur 6 die mit einem Widerstand überbrückte Diode bei RC- Überbrückung des Schalters,

Figur 7 der zeitliche Verlauf von Laststrom und Spannung am kapazitiven Energiespeicher bei einem Durchschlag im Klystron,

Figur 8 ein Beispiel für den eingangsseitigen Aufbau eines Leistungsmodulators.

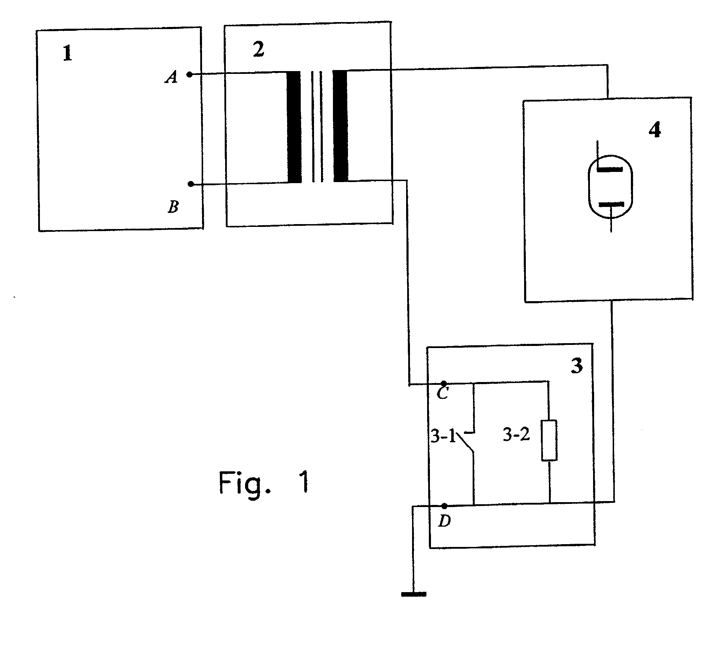

Der Leistungsimpulsformer 1 mit dem Aufladungssystem ist gemäß Fig. 1 an den Eingang des Pulstransformators 2, an die primärseitige Wicklung, angeschlossen. Die Ausgangspannung des Leistungsimpulsformers wird für die Last 4 über den Pulstransformator 2 transformiert, im allgemeinen hochtransformiert. Die lastseitige Wicklung, auch Sekundärwicklung genannt, des Pulstransformators 2 bildet mit der Last 4 und der zusätzlichen Schutzschaltung 3 einen Stromkreis. Die Last 4 ist hier ein Klystron mit rein ohmschem Charakter. Der gesteuerte Schalter in der zusätzlichen Schutzschaltung 3 ist ein Halbleiterschalter aus IGBT's (Insulated Gate Bipolar Transistor) oder IGCT's (Integrated Gate Commutated Thyristor), die je nach aufrechtzuerhaltendem Potentialunterschied in ausreichender Zahl in Reihe geschaltet sind und je nach zu führendem Strom sind dann eventuell solche Reihen an IGBT's oder IGCT's parallel geschaltet. Andersartige Schalter, wie Vakuumschalter sind auch einsetzbar, wenn, wie gesagt, die Anforderungen damit eingehalten werden können.

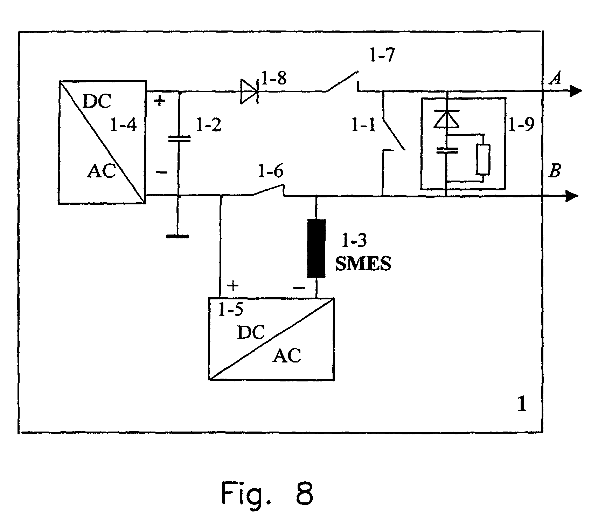

Der Leistungsimpulsformer 1 (Figur 8) wird gemäß DE 44 40 013 aufgebaut und zum Schutz des Klystrons bei Durchschlag in ihm mit dem Ignitron- Schalter und der Schutzschaltung ergänzt. Der Leistungsimpulsformer 1 ist ein System mit den zwei Energiespeichern, nämlich dem Kondensator 1-2 und dem supraleitenden magnetischen Energiespeicher 1-3, kurz SMES. Die Stromquelle 1-4 zum Laden des Kondensators 1-2 ist ein steuerbares Netzgerät mit dem die vorgesehene Spannung am Kondensator 1-2 aufgebaut wird. Die Spannungsquelle 1-5 zum Laden des SMES 1-3 ist ein steuerbares Netzgerät, mit dem der vorgesehene Strom in dem SMES 1-3 aufgebaut wird. Die Hochspannungsdiode 1-8 im Lastkreis verhindert eine Stromumkehr. Die Schutzschaltung 1-9 absorbiert die im Pulstransformator gespeicherte Energie.

Der Schalter 3-1 in der zusätzlichen Schutzschaltung 3 (Figur 1) besteht aus in Reihe geschalteten IGET's oder IGCT's. Der Widerstand 3-2 dient zum Absorbieren der im Pulstransformator gespeicherten Energie.

Geläufige Dinge wie Meßeinrichtungen, einen Geber zur Signalisation eines Durchschlages im Klystron, Schutzbeschaltungen und eine daran gekoppelte Steuerelektronik sind der Übersicht halber und wegen bekannter Technik nicht in die Figuren 1 bis 6 und 8 eingezeichnet.

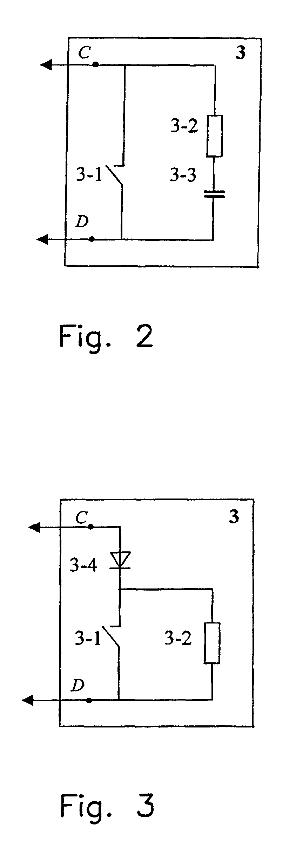

In den Figuren 2, 4 bis 6 werden die Varianten der Bauweise der Schutzschaltung 3 aus Figur 1 oder 3 gezeigt.

Der Kondensator 3-3 ist ein Hochspannungskondensator zum Formieren des quasirechteckigen Impulses auf der lastseitigen Wicklung des Pulstransformators 2 bei einem Durchschlag im Klystron. Die Hochspannungsdiode 3-4 verhindert eine Stromumkehr. Der Widerstand 3-5 begrenzt die Spannung an der Diode 3 - 4 und gewährleistet die Dissipation der in der Hauptinduktivität gespeicherten Energie.

Der Leistungsmodulator arbeitet folgendermaßen (s. Fig. 1 bis 6 und 8):

Während der Pulspause wird der Kondensator 1-2 auf der Eingangsseite über die Stromquelle 1-4 auf die vorgesehene Spannung und der SMES 1-3 über die Spannungsquelle 1-5 auf den vorgesehenen Strom aufgeladen (Figur 8). Damit sind die vorgegebenen Anfangsbedingungen für den Strom im SMES 1-3 und die Spannung am Kondensator 1-2 eingestellt und der Modulator kann betrieben werden. D. h. die beiden Schalter 1-6 und 1-7 können synchron in ihre komplementären Zustande versetzt werden. Gleichzeitig mit dem Schalter 1-7 wird der Schalter 3-1 in der zusätzlichen Schutzschaltung 3 geschaltet.

Ist der Schalter 1-7 gleichzeitig mit dem o. e. Schalter 3-1 im leitenden Zustand, dann gilt unter Vernachlässigung der Verluste im Entladungskreis des Speichers, der Beiträge der Stromquelle 1 - 4 und der Spannungsquelle 1 - 5 sowie der parasitären Parameter des Pulstransformators 2 für die Spannung und für den Strom am Eingang des Pulstransformators 2:

$$u\,(t) = u_{SMES}\,(t) + u_c(t) \tag{1}$$

und

$$i\,(t) = [I(0) * (\cos(bt) - (a/b) * \sin(bt)) - U_0/L*1/b*\sin(bt)]e^{-at} \tag{2}$$

Dabei ist

$$a = R/2L$$

die Last dividiert durch die doppelte Energiespeicherinduktivität, und b läßt sich aus

$$b^2 = 1/LC - a^2$$

bestimmen, mit C als der Kondensatorkapazität. Dabei ist die Spannung an der Sekundärwicklung des Pulstransformators praktisch gleich der Spannung am Klystron.

Die Gleichung (2) für i(t) beschreibt das transiente Entladen der Energiespeicher C und L während der Impulsdauer bei normalem Betrieb.

Im Fall eines Durchschlags (bei $t = t_d$) im Klystron sperrt der Schalter 3-1 (siehe Figuren 1, 2 und 3 bis 6), und in Reihe mit dem Klystron wird der Widerstand 3-2 geschaltet. Gleichzeitig, oder mit einer geringen Verzögerung, schaltet sich das Ignitron 1-1 (siehe Fig. 8) ein und der Energiefluß von den Energiespeichern 1-2 und 1-3 zur Last (zum Klystron) wird unterbrochen. Als Energiequelle, die für das Klystron gefährlich werden könnte, bleibt der Pulstransfomator 2. Die Energie, die in der Streuinduktivität des Pulstransformators nach der Anstiegszeit gespeichert ist sowie die in der Hauptinduktivität zum Ende des Impulses gespeicherte Energie überschreiten um das 5- bis 15-fache die zulässige Energie, die bei einem Durchschlag an das Klystron abgegeben werden darf.

Nach dem Öffnen des Schalters 3-1, siehe Figur 1, kann die Stromänderung in der Streuinduktivität des Pulstransformators 2 durch folgende Näherungsgleichung dargestellt werden:

$$i_{Ls}(t) \approx i_\mu(t_d) + i_{Ls}(t_d)e^{-tR/Ls} \tag{3},$$

wobei der Strom im Klystron sich folgendermaßen verhält:

$$i_{Kl}(t) \approx i_{Ls}(t_d)e^{-tR/Ls} \tag{4}$$

Es ist:

R      der Widerstand 3 - 2,
Ls     die Streuinduktivität des Pulstransformators 2,
$i_\mu(t_d)$    der Wert des Magnetisierungsstroms des Pulstransformators im Moment $t_d$ des Durchschlags im Klystron 4
$i_{Ls}(t)$    der Wert des Stromes über die Streuinduktivität im Moment des Durchschlags im Klystron 4.

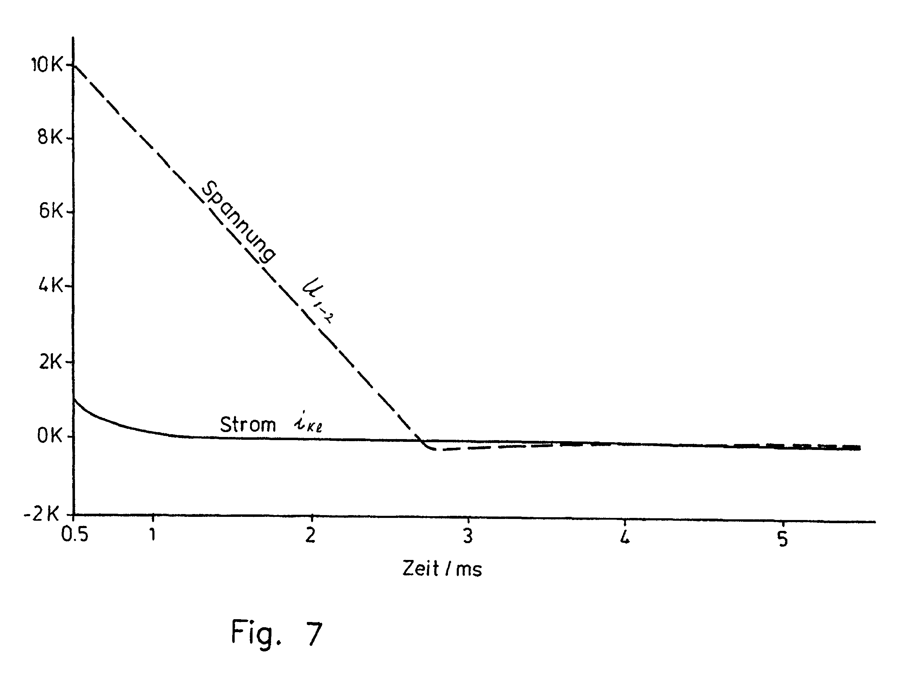

Nach drei Zeitkonstanten, 3Ls/R, ist der Strom im Klystron 4 praktisch gleich Null (sieh Figur 7). Während dieser Zeit bleibt der Magnetisierungsstrom praktisch unverändert und fließt nach wie vor durch die Primärwicklung des Pulstransformators 2.

Der Strom in den Entladestromkreisen der Energiespeicher wird nach wie vor durch die Gleichung (2) dargestellt, unter Berücksichtigung, daß für das betrachtete Zeitintervall R = O und a = O gilt und die Anfangsbedingungen für den Moment des Durchschlags im Klystron definiert werden.

Nach der Änderung der Polarität der Spannung am Kondensator 1-2 wird der Thyristorschalter 1-6 geschaltet. Dabei wird die Spannung mit der geänderten Polarität an das Ignitron 1-1 und die Diode 1-8 angelegt. Die Diode 1-8 sperrt und der Stromfluß von den Energiespeichern zur Last wird unterbrochen. Nach dem Unterbrechen des Stromflusses von den Energiespeichern und dem Sperren des Ignitrons 1-1 fließt der Magnetisierungsstrom über die Elemente der Zweipol-Schutzschaltung 1-9. Dabei wird über der Primärwicklung des Impulstransformators und am Klystron ein Spannungsimpuls mit umgekehrter Polarität erzeugt.

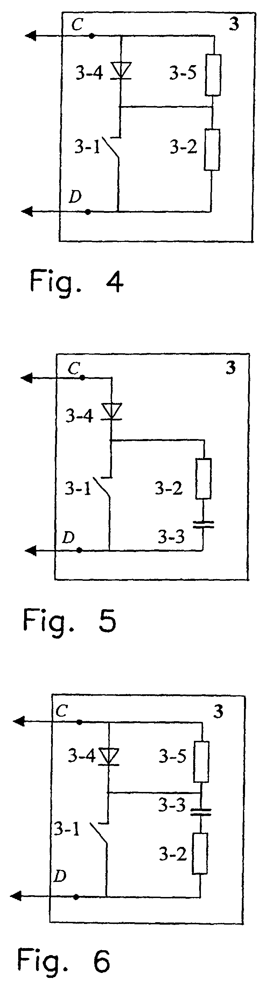

Falls im Klystron 4 kein Durchschlag in umgekehrter Richtung erfolgt, wird die in der Hauptinduktivität des Pulstransformators gespeicherte Energie in den Elementen des Zweipols 1-9 absorbiert. Falls im Klystron 4 ein Durchschlag in umgekehrter Richtung erfolgt, so kann ein wesentlicher Teil der in der Hauptinduktivität des Pulstransformators 2 gespeicherten Energie im Klystron 4 freigesetzt werden. Um einen Durchschlag im Klystron 4 in umgekehrter Richtung zu verhindern, ist in den Ausführungsvarianten nach Figur 3 bis 6 der Schutzschaltung 3 die Diode 3-4 in Reihe mit dem Schalter 3-1 geschaltet. Der Widerstand 3-5 dient zur Begrenzung der Spannung über der Diode 3-4 (Figur 4 und 6).

Der Schalter 3-1 ist so ausgeführt, daß er bei Fehlen eines Steuersignals sperrt, wobei außerdem garantiert wird, daß das Steuersignal nur während der Zeit des Hochspannungsimpulses gegeben wird, und daß bei einem Durchschlag im Klystron das Steuersignal weggenommen werden kann. Dabei wird im Modulator garantiert, daß die bei einem Durchschlag im Klystron freigesetzte Energie begrenzt wird, selbst wenn alle auf der Eingangsseite des Pulstransformators eingesetzten Schalter oder ihre Steuereinrichtungen versagen.

Wenn im Falle eines Durchschlags im Klystron das Ignitron 1-1 nicht schaltet, so wird die Entladung der Energiespeicher 1-2 und 1-3 über die Last fortgesetzt. Dann wird durch den Spannungsabfall über dem Widerstand 3-2 (sieh Fig. 1) eine Sättigung des Kerns des Pulstransformators 2 bewirkt und die im Klystron freigesetzte Energie begrenzt. Das geschieht im Moment $t_s$, der durch die folgende Gleichung definiert wird:

$$[\Delta B] = (1/WS) * [\int_{t_d}^{t_s} u_{Kl}(t)\,dt + \int_{t_d}^{t_s} i_{Kl}(t)R_{3-2}\,dt], \quad (5)$$

wobei ist:

[ΔB]   die Sättigungsinduktion des Kerns des Pulstransformators 2,
W   die Windungszahl der Sekundärwicklung des Pulstransformators 2,
S   der Querschnitt des Kernes vom Pulstransformator 2
$u_{Kl}(t)$   die Spannung am Klystron,
$i_{Kl}(t)$   der Strom im Klystron (siehe Formel oben,
$R_{3-2}$   der Widerstand (siehe Fig. 1).

Dabei werden die Verluste im Klystron beim Durchschlag durch folgende Gleichung bestimmt:

$$W_{Kl} = U_{Kl} * [\int_{t_d}^{t_s} i_{Kl}(t)\,dt + \int_{0}^{3\tau} i_{Kl}(t_s)e^{-t*R(3-2)/Ls}\,dt] \quad (6)$$

Auf diese Weise wird die im Klystron bei einem Durchschlag freigesetzte Energie durch den Augenblick der Sättigung des Pulstransformators $t_s$ bestimmt, und zwar durch die Auswahl des Widerstandes $R_{3-1}$ (siehe Fig. 1, 3 und 4 sowie obige Gleichung). Der Augenblick $t_s$ der Sättigung hängt auch vom Augenblick des Durchschlags $t_d$ ab (siehe Gleichung (5)).

In dem betrachteten Beispiel wird der Strom im Klystron durch die Induktivität des SMES begrenzt und verringert sich in dem Maße, wie der Kondensator 1-2 umgeladen wird. In diesem Fall ist zur Sicherung einer optimalen Impulsform über der Transformatorwicklung (quasirechteckig) der Kondensator 3-3 in Reihe mit dem Widerstand 3-2 in die Schutzschaltung 3 geschaltet (siehe Fig. 2, 5, 6). Das erlaubt eine Verringerung der bei einem Durchschlag im Klystron freigesetzten Energie um 30-50% zusätzlich zu den Reduktionen aufgrund des zugeschalteten sekundärseitigen Widerstands und des Sättigungseffekts im Pulstransformator.

Im Durchführungsbeispiel sind die Bauteile des Leistungsmodulators, wie folgt, dimensioniert worden:

| | |
|---|---|
| Das Klystron | R = 8 Ω, |
| Induktivität des SUMS | L = 70 mH, |
| Anfangsstrom im SMES | $I_{SMES}$ = 1250 A, |
| Kondensatorspannung | $U_c$ = 12 kV, |
| Kondensatorkapazität | C = 300 μF, |
| Streuinduktivität des Pulstransformators | $L_s$ = 375 μH, |
| Hauptinduktivität des Pulstransformators | $L_H$ = 1,27 H, |
| Sattigungsinduktion des Kernes vom Pulstransformator | 2 [ΔB] = 2,7 T, |
| Windungszahl der Primärwicklung des Pulstransformators | 2 W= 128, |
| Querschnitt des Kernes vom Pulstransformator 2 | S = 500 qcm, |
| Widerstand $R_{3-2}$ (siehe Fig. 1) | $R_{3-2}$ = 1,2 Ω, |
| Spannung am Klystron bei dem Durchschlag im Klystron V. | $U_{Kl}$ = 100 |

Die Parameter der Widerstände, der Induktivität und der Kapazität sind für die Primärwicklung angegeben.
In dem betrachteten Beispiel beträgt die Energie, die im Klystron bei einem Durchschlag freigesetzt wird, ca. 5 J und damit wesentlich weniger als die zulässigen 20 J.
Im Fall eines Defektes des primärseitigen seriellen Schalters (oder der Steuereinrichtung), ist die kommutierte Leistung bei Verwendung des zusätzlichen Schalters 3-1 auf der Sekundärseite des Pulstransformators um fast eine Größenordnung geringer als die kommutierte Leistung bei Verwendung eines Reserveschalters im Entladestromkreis der Energiespeicher auf der Primärseite, wie es Stand der Technik ist.

Im Fall eines Defektes des primärseitigen seriellen Schalters (oder der Steuereinrichtung) ist die im Klystron bei einem Durchschlag freigesetzte Energie mit der vorgeschlagenen Schaltung mehr als um eine Größenordnung geringer als in einem Modulator nach dem Stand der Technik.

Im Fall eines Defektes aller Schalter (oder ihrer Steuereinrichtung) auf der Primärseite des Pulstransformators 2 in einem Leistungspulsformer, beträgt die im Klystron freigesetzte Energie in dem hier betrachteten Beispiel ca. 65 J, falls im Klystron 400 µsec nach Beginn des Hochspannungsimpulses ein Durchschlag erfolgt. Das ist um mehr als eine Größenordnung geringer als in einem Modulator nach dem Stand der Technik.

In Fig. 7 sind der zeitliche Verlauf des Stromes $i_{Kl}$ im Klystron und der Spannung $u_{1-2}$ am Kondensator 1-2 (Energiespeicher) dargestellt, falls im Klystron 400 µs nach Beginn des Hochspannungsimpulses ein Durchschlag erfolgt. Alle Schalter reagieren dabei entsprechend ihrer Bestimmung; die Schutzschaltung ist gemäß Fig. 1 ausgeführt.

**Patentansprüche**

1. Schutzsystem in einem Leistungsmodulator zum Schutze einer angeschlossenen Last, bestehend aus:

   einem Aufladungssystem,
   einem Leistungsimpulsformer,
   einem Steuersystem,
   einem Pulstransformator (2) mit einer ersten Schutzschaltung (1) in Form einer Crowbar-Schaltung auf der Eingangsseite und der auf seiner Ausgangsseite angeschlossenen Last (4),

   **dadurch gekennzeichnet,**
   **daß** das Schutzsystem eine weitere, zweite Schutzschaltung (3) auf der Ausgangsseite des Pulstransformators (2) hat, die zwischen der niederpotentialen Klemme (C) und dem Erdpotential (D) eingebaut ist und aus einem gesteuerten Schalter (3-1), der durch einen Widerstand (3-2) überbrückt ist, besteht.

2. Schutzsystem nach Anspruch 1,
   **dadurch gekennzeichnet,**
   **daß** den Schalter (3-1) eine Reihenschaltung aus dem Widerstand (3-2) und einem Kondensator (3-3) überbrückt.

3. Schutzsystem nach den Ansprüchen 1 und 2,
   **dadurch gekennzeichnet,**
   **daß** zwischen der niederpotentialen Klemme (C) auf der Lastseite des Pulstransformators (2) und dem Erdpotentialpunkt (D) eine Diode (3-4) in Reihe zu der Parallelschaltung aus dem Schalter (3-1) und der Brücke (3-2) oder (3-2, 3-3) in Richtung des Betriebsstromes in der Last (4) geschaltet ist.

4. Schutzsytem nach Anspruch 3,
   **dadurch gekennzeichnet,**
   **daß** die Diode (3-4) durch einen Widerstand (3-5) überbrückt ist.

5. Schutzsytem nach einem der vorangehenden Ansprüche 1 bis 4,
   **dadurch gekennzeichnet,**
   **daß** die Last (4) eine Hochleistungsbaukomponente, wie ein Klystron, ein Magnetron oder eine Senderöhre, ist.

**Claims**

1. Protective system in a power modulator for the protection of a connected load, said system comprising:

   a charging system,
   a power pulse former,
   a control system, and
   a pulse transformer (2), having a first protective circuit (1), in the form of a Crowbar circuit, on the input side and having the load (4), which is connected on the output side of said transformer,

   **characterised in that** the protective system has an additional, second protective circuit (3) on the output side of the pulse transformer (2), which second circuit is installed between the low-potential terminal (C) and the earth potential (D) and comprises a controlled switch (3-1) which is bridged by a resistor (3-2).

2. Protective system according to claim 1, **characterised in that** a series-circuit, comprising the resistor (3-2) and a capacitor (3-3), bridges the switch (3-1).

3. Protective system according to claims 1 and 2, **characterised in that** a diode (3-4) is connected in series with a parallel circuit, which comprises the switch (3-1) and the bridge (3-2) or (3-2, 3-3), in the direction of the operational current in the load (4) between the low-potential terminal (C) on the load side of the pulse transformer (2) and the earth potential point (D).

4. Protective system according to claim 3, **characterised in that** the diode (3-4) is bridged by a resistor (3-5).

5. Protective system according to one of the preceding claims 1 to 4, **characterised in that** the load (4) is a heavy-duty structural component, such as a klystron, a magnetron or a transmitting tube.


**Revendications**

1. Système de protection pour un modulateur de puissance destiné à protéger une charge reliée à celui-ci et comprenant :

   - un système de charge,
   - un transformateur d'impulsions de puissance,
   - un système de commande,
   - une charge (4) reliée au côté de sortie du transformateur d'impulsions (2) par un premier circuit protecteur (1) sous la forme d'un circuit Crowbar du côté de l'entrée et du côté de la sortie,

   **caractérisé en ce que**
   le système de protection comporte un autre second circuit de protection (3) du côté de sortie du transformateur d'impulsions (2), ce circuit étant installé entre la borne basse tension (C) et la masse (D) et se compose d'un commutateur commandé (3-1) avec en dérivation une résistance (3-2).

2. Système de protection selon la revendication 1,
   **caractérisé en ce qu'**
   un montage en série formé de la résistance (3-2) et d'un condensateur (3-3) est prévu aux bornes du commutateur (3-1).

3. Système de protection selon l'une quelconque des revendications 1 et 2,
   **caractérisé par**
   une diode (3-4) branchée en série sur le montage en parallèle formé du commutateur (3-1) et du pont (3-2) ou (3-2, 3-3), dans le sens du courant de fonctionnement traversant la charge (4), cette diode étant prévue entre la borne basse tension (C) du côté de la charge pour le transformateur impulsionnel (2) et le point de potentiel de masse (D).

4. Système de protection selon la revendication 3,
   **caractérisé en ce que**
   la diode (3-4) comporte à ses bornes une résistance (3-5).

5. Système de protection selon l'une quelconque des revendications précédentes 1-4,
   **caractérisé en ce que**
   la charge (4) est un composant de haute puissance comme un klystron, un magnétron ou un tube émetteur.

Fig. 1

Fig. 2

Fig. 3

Fig. 4

Fig. 5

Fig. 6

Fig. 7

EP 1 131 874 B1

Fig. 8